# EUROPÄISCHE PATENTSCHRIFT

(11) **EP 1 620 893 B1**
(45) Veröffentlichungstag und Bekanntmachung des Hinweises auf die Patenterteilung: **27.02.2019**
(21) Anmeldenummer: 04730955.4
(22) Anmeldetag: 04.05.2004
(51) Int. Cl.: H01L 25/065, H01L 23/31, H01L 21/68, H01L 21/56, H01L 23/16

(54) **VERFAHREN ZUR HERSTELLUNG EINES NUTZENS UND VERFAHREN ZUR HERSTELLUNG ELEKTRONISCHER BAUTEILE MIT GESTAPELTEN HALBLEITERCHIPS AUS DEM NUTZEN**
METHOD FOR THE MANUFACTURE OF A PANEL AND METHOD FOR THE MANUFACTURE OF ELECTRONIC COMPONENTS COMPRISING STACKED SEMICONDUCTOR CHIPS FROM THE PANEL
PROCÉDÉ DE FABRICATION D' UNE PLAQUETTE ET PROCÉDÉ DE FABRICATION DE COMPOSANTS ELECTRONIQUES COMPRENANT PUCES A SEMI-CONDUCTEUR EMPILEES

(30) Priorität: 07.05.2003 DE 10320579
(43) Veröffentlichungstag der Anmeldung: 01.02.2006
(73) Patentinhaber: Infineon Technologies AG, 85579 Neubiberg (DE)
(72) Erfinder: GOLLER, Bernd, 83624 Otterfing (DE)
(74) Vertreter: Moore, Joanne Camilla
(86) Internationale Anmeldenummer: PCT/DE2004/000936
(87) Internationale Veröffentlichungsnummer: WO 2004/100261

(56) Entgegenhaltungen:
- WO-A-02/15266
- WO-A-02/33751
- US-A1- 2001 015 496
- US-A1- 2001 038 151
- US-A1- 2003 068 852
- US-B1- 6 359 335

## Beschreibung

Die Erfindung betrifft ein Verfahren zum Herstellen eines Nutzens und eines elektronischen Bauteils mit gestapelten Halbleiterchips.

Mit zunehmenden Anforderungen an Miniaturisierungsgrad und Schaltungsdichte von elektronischen Bauteilen werden die Herstellungsverfahren derartiger Bauteile komplexer, die Ausfallraten größer und das Ziel der Kostenminimierung immer entscheidender. Dabei ist der Übergang von inneren elektrischen Verbindungen zwischen den Halbleiterchips zu äußeren Verbindungen über Außenkontakte, die eine vorgegebene Handhabungsbeziehungsweise Anschlussgröße nicht unterschreiten dürfen, problematisch.

Die US 2001/0038151 A1 und die US 2001/0015496 A1 offenbaren jeweils ein Bauteil mit zwei gestapelten Halbleiterchips. Die WO 02/15266 A2 offenbart ein Herstellungsverfahren für ein elektronisches Bauteil, bei dem ein Halbleiterchip in Einkapselungsmaterial eingebettet und mit auf der Einkapselung verlaufenden Leiterbahnen versehen wird.

Aufgabe der Erfindung ist es, ein Verfahren zum Herstellen eines elektronischen Bauteils mit inneren elektrischen Verbindungen und mit Außenkontakten mithilfe von geeigneten Halbleiterwafern und geeigneten Nutzen zu schaffen, bei dem eine weiterführende Miniaturisierung und eine ausreichende äußere Handhabungs- beziehungsweise Anschlussgröße möglich wird und die Herstellungskosten vermindert sind.

Gelöst wird diese Aufgabe mit dem Gegenstand des unabhängigen Anspruchs 1. Eine vorteilhafte Ausführungsform ergibt sich aus dem abhängigen Anspruch.

Zunächst wird ein Halbleiterwafer bereitgestellt, der eine Oberseite aufweist, die in Zeilen und Spalten angeordnete Halbleiterchippositionen mit integrierten Schaltungen für erste Halbleiterchips aufweist. Diese Halbleiterchippositionen weisen jeweils einen zentralen Bereich mit Zentralkontaktflächen und einen Randbereich mit Randkontaktflächen auf. Die Zentralkontaktflächen sind über Leiterbahnen mit den Randkontaktflächen elektrisch leitend verbunden.

Darüber hinaus weist der Halbleiterwafer zweite Halbleiterchips mit zweiten Kontaktflächen auf. Dabei sind die zweiten Halbleiterchips auf den zentralen Bereichen der ersten Halbleiterchips in Flip-Chip-Technik angebracht, sodass die ersten Zentralkontaktflächen mit den zweiten Kontaktflächen elektrisch in Verbindung stehen. Durch eine Einebnungsschicht auf der Oberseite des Halbleiterwafers wird eine ebene, neue Oberseite geschaffen, unter der die zweiten Halbleiterchips in der Einebnungsschicht eingebettet sind.

Der Vorteil dieses Halbleiterwafers ist es, dass er in jeder Bauteilposition bereits einen gestapelten, zweiten Halbleiterchip aufweist, wobei dieser Stapel noch vor dem Auftrennen des Halbleiterwafers existiert, sodass alle weiteren Bearbeitungsschritte gleichzeitig für mehrere Chippositionen erfolgen können.

Die Anzahl der zweiten Kontaktflächen des zweiten Halbleiterchips entspricht der Anzahl der Zentralkontaktflächen in jeder Halbleiterchipposition, sodass durch die Verbindung zwischen ersten Zentralkontaktflächen und zweiten Kontaktflächen sowohl die Signalanschlüsse als auch die Versorgungsanschlüsse des zweiten Halbleiterchips mit dem entsprechenden Anschlüssen in den Halbleiterpositionen für das erste Halbleiterchip in Kontakt stehen. Die Anzahl der zweiten Kontaktflächen entspricht außerdem der Anzahl der Randkontaktflächen, die über Leiterbahnen mit den Zentralkontaktflächen in Verbindung stehen. Somit können Signale der zweiten Kontaktflächen des zweiten Halbleiterchips über die Zentralkontaktflächen, die Leiterbahnen und die Randkontaktflächen weitergegeben werden. Andererseits können über die Randkontaktflächen, die Leiterbahnen, die Zentralkontaktflächen und die zweiten Kontaktflächen Versorgungsströme und Versorgungsspannung gleichzeitig sowohl dem ersten Halbleiterchip als auch dem zweiten Halbleiterchip zugeführt werden.

Die Verbindung der Zentralkontaktflächen mit den zweiten Kontaktflächen kann über Flip-Chip-Kontakte erfolgen. Derartige Flip-Chip-Kontakte des zweiten Halbleiterchips sind zwar kleiner als Außenkontakte eines elektronischen Bauteils, benötigen jedoch eine Mindestgröße der zweiten Kontaktflächen beziehungsweise der Zentralkontaktflächen um eine elektrische Verbindung zu gewährleisten. Demgegenüber können die Randflächen, die nicht von der Bildung von Verbindungskontakten abhängen, in ihrer Größe bis auf ein technologisch gefordertes Mindestmaß, beispielsweise photographischer Auflösung oder elektronenoptischer Auflösung je nach eingesetzter Technologie beliebig verkleinert werden. Über die Leiterbahnen, die in etwa mit gleicher Anzahl wie die Zentralkontaktflächen in jeder Halbleiterchipposition vorgesehen sind, können sämtliche Signal- und Versorgungsanschlüsse beider Halbleiterstrukturen, nämlich des ersten Halbleiterchips und des zweiten Halbleiterchips auf entsprechende Randkontakte gelegt werden. Der Flächenbedarf für die Randkontakte kann entsprechend dem minimalen Flächenbedarf jedes einzelnen Randkontaktes minimiert werden. Entsprechend ist es möglich, die Packungsdichte der Randkontaktflächen größer als die Packungsdichte der Zentralkontaktflächen zu gestalten. Ein weiterer Beitrag zur Minimierung von elektronischen Bauteilen mit Halbleiterchips wird somit erreicht.

Um den Volumenbedarf der auf den Halbleiterchippositionen gestapelten zweiten Halbleiterchips zu vermindern, werden die Halbleiterchips in ihrer Dicke geringer als die Dicke des Halbleiterwafers ausgeführt. Da die zweiten Halbleiterchips auf einer planaren Oberseite eines Halbleiterwafers angeordnet sind, und über die Flip-Chip-Kontakte nicht nur elektrisch mit dem Zentralbereich in den Halbleiterchippositionen verbunden sind, sondern auch mechanisch äußerst stabil fixiert sind, werden zunächst Halbleiterchips aufgebracht, die eine normale Halbleiterchipdicke aufweisen und erst ein Dünnschleifen vorgenommen, wenn diese zweiten Halbleiterchips in den Bauteilpositionen des Halbleiterwafers mechanisch ausgerichtet und fixiert sind. Die Ausschussrate dünngeschliffener Halbleiterchips wird dadurch minimiert, zumal nach dem Dünnschleifen diese Halbleiterchips in keiner Weise mehr gefahrlos zu handhaben, zu transportieren oder in anderer Weise zu bearbeiten sind. Die Kosten für elektronische Bauteile mit gestapelten dünngeschliffenen Halbleiterchips können somit vermindert werden.

Die Oberseite des Halbleiterwafers wird durch Aufsetzen und Anbringen der zweiten Halbleiterchips äußerst uneben und für weitere Bearbeitungsschritte unbrauchbar. Um eine ebene gleichmäßige Schicht für weitere Bearbeitungsschritte zur Verfügung zu stellen, weist deshalb der Halbleiterwafer eine Einebnungsschicht auf seiner Oberseite auf, in welche die zweiten Halbleiterchips eingebettet sind.

Reicht die Halbleiterchipfläche in jeder Halbleiterchipposition des Halbleiterwafers nicht aus, um eine ausreichende Anzahl an Außenkontakten bereits auf dem Halbleiterwafer anzuordnen, so wird gemäß der Erfindung ein Nutzen geschaffen, der eine beliebig große Fläche für Außenkontakte eines elektronischen Bauteils zur Verfügung stellt.

Im Gegensatz zum Halbleiterwafer weist ein derartiger Nutzen eine Oberseite auf, die in Zeilen und Spalten angeordnete Bauteilpositionen aufweist und nicht nur Halbleiterchippositionen. Innerhalb jeder Bauteilposition sind zwei Halbleiterchips aufeinander gestapelt. Entsprechend aufgebaute Halbleiterwafer können zu derartigen Halbleiterchipstapeln getrennt werden, noch bevor die Halbleiterwafer Durchkontakte, Umverdrahtungslagen und/oder Außenkontakte aufweisen, zumal diese Komponenten auf der Oberseite des Nutzens angeordnet sein können. Dazu sind in dem Nutzen die gestapelten Halbleiterchips wenigstens mit ihren Randseiten in einer Kunststoffmasse zu einer Kunststoffverbundplatte eingebettet, wobei die gestapelten Halbleiterchips eine Einebnungsschicht aufweisen, in der der jeweilige zweite Halbleiterchip eingebettet ist.

Die Kunststoffmasse und die Oberseite der Einebnungsschichten der gestapelten Halbleiterchips bilden eine gemeinsame Fläche, auf der eine Umverdrahtungslage angeordnet ist. Diese Umverdrahtungslage auf einem Nutzen ist großflächiger als die Umverdrahtungslage auf einem Halbleiterwafer, da sie sich über die Einebnungsschicht und über Bereiche der Kunststoffmasse erstrecken kann. Somit lassen sich mit dem Nutzen in vorteilhafter Weise wesentlich mehr Außenkontaktflächen in der Umverdrahtungsstruktur und entsprechend auch mehr Außenkontakte des elektronischen Bauteils in jeder der Bauteilpositionen des Nutzens vorsehen.

Um sowohl die zweiten Kontaktflächen als auch die ersten Zentralkontaktflächen mit den Außenkontakten des Nutzens in jeder Bauteilposition zu verbinden, sind neben der Umverdrahtungslage Durchkontakte zu den Randkontaktflächen auf der Oberseite des ersten Halbleiterchips vorgesehen. Die Außenkontakte können auf den Außenkontaktflächen der Umverdrahtungslage außerhalb des Bereichs der Einebnungsschicht des Halbleiterchipstapels angeordnet sein und somit auf der Kunststoffmasse des Nutzens liegen. Zusätzlich können sie auf der Einebnungsschicht des Halbleiterstapels angeordnet sein. Schließlich ist es möglich, die Außenkontakte gleichmäßig verteilt auf jeder Bauteilposition vorzusehen.

Bauteile, die aus einem entsprechend fertiggestellten Nutzen herausgetrennt werden, weisen einen ersten Halbleiterchip auf, der einen zentralen Bereich mit Zentralkontaktflächen und einen Randbereich mit Randkontaktflächen besitzt. Dabei sind die Zentralkontaktflächen mit den Randkontaktflächen über Leiterbahnen verbunden. Ferner weist das elektronische Bauteil einen zweiten Halbleiterchip auf, der zweiten Kontaktflächen besitzt. Der zweite Halbleiterchip ist auf dem zentralen Bereich des ersten Halbleiterchips angeordnet und die Zentralkontaktflächen stehen mit den zweiten Kontaktflächen elektrisch in Verbindung. Der zweite Halbleiterchip ist in eine Einebnungsschicht eingebettet, wobei die Einebnungsschicht Durchkontakte aufweist, die mit den Randkontaktflächen elektrisch in Verbindung stehen. Darüber hinaus weist das elektronische Bauteil eine mehrschichtige Umverdrahtungslage auf. Diese Umverdrahtungslage ist auf der Einebnungsschicht angeordnet und verbindet Außenkontakte des elektronischen Bauteils, die auf Außenkontaktflächen der Umverdrahtungsstruktur angeordnet sind, über Umverdrahtungsleitungen mit Durchkontakten, die ihrerseits mit den Randkontaktflächen verbunden sind.

Ein derartiges elektronisches Bauteil hat den Vorteil, dass es räumlich kompakt aufgebaut ist, eine minimale Anzahl von Herstellungsschritten benötigt und damit kostengünstig herstellbar wird und kurze Verbindungen zwischen den Zentralkontaktflächen des ersten Halbleiterchips, den zweiten Kontaktflächen des zweiten Halbleiterchips und den Außenkontaktflächen ermöglicht. Der erste Halbleiterchip kann eine größere Oberseite und eine größere Dicke als der zweite Halbleiterchip aufweisen, wodurch die Kompaktheit des elektronischen Bauteils verbessert und der Raumbedarf des elektronischen Bauteils vermindert wird.

Die Verbindungen zwischen ersten Zentralkontaktflächen und zweiten Kontaktflächen können Flip-Chip-Kontakte aufweisen, deren Flächen größer sind als die Querschnittsflächen der Durchkontakte zu den Randkontaktflächen. Diese Querschnittsflächen können kreisförmig sein und durch säulenartige Durchkontakte verwirklicht werden. Ein Vorteil der kleineren Querschnittsflächen der Durchkontakte gegenüber den Querschnittsflächen von Flip-Chip-Kontakten liegt darin, dass in den Randbereichen des ersten Halbleiterchips eine höhere Packungsdichte der Durchkontakte erreicht werden kann als bei Flip-Chip-Kontakten in dem zentralen Bereich des ersten Halbleiterchips.

Die Einebnungsschicht, auf der die Umverdrahtungslage angeordnet ist, kann Polyimid aufweisen und eine Dicke besitzen, die geringfügig größer ist als die Dicke von dünngeschliffenen zweiten Halbleiterchips mit ihren Flip-Chip-Kontakten. So kann die Dicke einer derartigen Einebnungsschicht zwischen 80 und 120 µm liegen, wenn dünngeschliffene Halbleiterchips von 50 bis 70 µm als zweite Halbleiterchips in Flip-Chip-Technik auf dem ersten Halbleiterchip angeordnet sind. Die Höhe der Flip-Chip-Kontakte liegt dabei zwischen 15 und 30 µm. Die Durchmesser der Durchkontakte können demgegenüber bis auf 0,5 µm reduziert werden. Vorzugsweise liegen die Durchmesser der Durchkontakte in einem Bereich zwischen 2 und 10 µm.

Ein Verfahren zur Herstellung eines Halbleiterwafers mit mehreren Halbleiterchippositionen für mehrere elektronische Bauteile weist die nachfolgenden Verfahrensschritte auf. Zunächst wird ein Halbleiterwafer bereitgestellt, der in Zeilen und Spalten angeordnete Halbleiterchippositionen mit integrierten Schaltungen für erste Halbleiterchips aufweist. Dabei weisen die Halbleiterchippositionen jeweils einen zentralen Bereich mit Zentralkontaktflächen und einen Randbereich mit Randkontaktflächen auf. Die Zentralkontaktflächen sind mit den Randkontaktflächen über Leiterbahnen elektrisch verbunden.

Dieser Halbleiterwafer wird mit zweiten Halbleiterchips in den zentralen Bereichen der Halbleiterchippositionen unter Freilassen der Randkontaktflächen bestückt. Als nächstes folgt dann ein Dünnschleifen der zweiten Halbleiterchips, die auf dem Halbleiterwafer fixiert sind. Auf den Halbleiterwafer wird dann eine Einebnungsmasse aufgebracht, in die die zweiten Halbleiterchips eingebettet werden. Nach dem Aufbringen der Einebnungsmasse kann diese zu einer Einebnungsschicht bearbeitet werden.

Dieses Verfahren hat den Vorteil, dass es auf Waferebene durchgeführt wird und insbesondere das Dünnschleifen der zweiten Halbleiterchips auf Waferebene durchgeführt werden kann, so dass eine äußerst geringe Ausschussrate erreichbar ist. Die zweiten Halbleiterchips sind nämlich vor dem Dünnschleifen in ihrer vollen Dicke äußerst stabile Chips und werden durch die Flip-Chip-Kontakte auf dem zentralen Bereich jeder Halbleiterchipposition fixiert, müssen nach dem Dünnschleifen nicht mehr von diesen Positionen entfernt werden.

Reicht die Fläche einer Halbleiterchipposition nicht aus, um ausreichend und genügend viele Außenkontakte eines elektronischen Bauteils aufzubringen, wird gemäß der Erfindung vor dem Aufbringen einer Umverdrahtungslage ein Nutzen hergestellt. Dazu werden die nachfolgenden Verfahrensschritte durchgeführt. Zunächst wird ein Halbleiterwafer mit gestapelten Halbleiterchips in einzelne Halbleiterchipstapel getrennt, wobei jeder dieser Chipstapel eine Einbettungsschicht aufweist, in der ein zweiter Halbleiterchip eingebettet ist, der mit Zentralkontakten eines ersten Halbleiterchips verbunden ist.

Diese in der Weise vereinzelte Halbleiterstapel werden auf eine Trägerfolie aufgebracht, wobei die Einebnungsschichten auf die Trägerfolie geklebt werden. Die einzelnen Halbleiterchipstapel werden in Zeilen und Spalten für entsprechend vorgesehene Bauteilpositionen des Nutzens auf die Trägerfolie aufgebracht. Anschließend werden die Halbleiterchipstapel in einer Kunststoffmasse unter Bilden einer Kunststoffverbundplatte eingebettet. Nach Aushärten des aufgebrachten Kunststoffes ist diese Kunststoffverbundplatte selbsttragend, so dass die Trägerfolie von der Kunststoffverbundplatte entfernt werden kann.

Mit Hilfe der Trägerfolie ist eine gemeinsame Oberseite aus Kunststoff und Einbettschichten der einzelnen Halbleiterchipstapel entstanden. Nun werden Durchgangsöffnungen mittels Photolithographie zu den Randkontaktflächen des ersten Halbleiterchips in die Einebnungsschicht eingebracht. Wobei mit der Photolithographie lediglich die Strukturierung erfolgt und mit Hilfe eines Lösungsmittels die Durchgangsöffnungen in die Einebnungsschicht hineingelöst werden.

Da die Durchgangsöffnungen bis zu den Randkontaktflächen des ersten Halbleiterchips reichen, kann nun eine Verbindung in Form von Durchkontakten durch Auffüllen der Durchgangsöffnungen zu den Randkontaktflächen mittels chemischer oder galvanischer Abscheidung hergestellt werden. Anschließend wird eine Umverdrahtungslage mit Umverdrahtungsleitungen von den Durchkontakten zu Außenkontaktflächen der Umverdrahtungslage aufgebracht. Nach Aufbringen einer Lötstopplackschicht unter Freilassen der Außenkontaktflächen der Umverdrahtungslage werden Außenkontakte auf diese freigelassenen Außenkontaktflächen aufgebracht. Das Aufbringen kann durch Auflöten von Lotbällen oder Lothöckern erfolgen. Zur Herstellung der elektronischen Bauteile muss der Nutzen in einzelne elektronische Bauteile zersägt oder in anderer Weise getrennt werden.

Zusammenfassend ist festzustellen, dass durch die Kombination einer "fine pitch-fähigen Flip-Chip-Montagetechnologie" mit dem Prozessansatz des "universal package" der Entwickler die Möglichkeit hat, den Zugriff zu Kontakten des zweiten Halbleiterchips über Kontakte auf dem ersten Halbleiterchip zu verwirklichen. Dies hat den Vorteil kurzer Signalwege, die für einen schnellen Zugriff und für kurze Taktzeiten bei Halbleiterspeichern und Mikroprozessoren entscheidend sind. Darüber hinaus ergibt sich der Vorteil eines sehr dünnen Gehäuses bei hoher Leitungsdichte durch Dünnschleifen der gestapelten Halbleiterchips. Darüber hinaus besteht die Möglichkeit, einen Wafertest durchzuführen, sobald die beiden Halbleiterchips auf einem Halbleiterwafer miteinander verbunden sind, da die Randkontaktflächen im Randbereich vor dem Aufbringen einer Einebnungsmasse für Testspitzen zugänglich sind.

Die Erfindung wird nun anhand der beigefügten Figuren näher erläutert.
- Figur 1: zeigt einen schematischen Querschnitt durch ein elektronisches Bauteil hergestellt nach dem erfindungsgemäßen Verfahren,
- Figur 2: zeigt einen schematischen Querschnitt durch einen Halbleiterwafer mit Halbleiterchippositionen, auf denen zweite Halbleiterchips angeordnet sind,
- Figur 3: zeigt einen schematischen Querschnitt durch den Halbleiterwafer gemäß Figur 2 nach einem Dünnschleifen der zweiten Halbleiterchips,
- Figur 4: zeigt einen schematischen Querschnitt durch einen Halbleiterwafer gemäß Figur 3 nach einem Aufbringen einer Einebnungsmasse auf die mit zweiten Halbleiterchips bestückte Oberseite des Halbleiterwafers,
- Figur 5: zeigt einen schematischen Querschnitt durch den Halbleiterwafer gemäß Figur 4 nach einem Bearbeiten der Einebnungsmasse zu einer Einebnungsschicht,
- Figur 6: zeigt einen schematischen Querschnitt durch einen Nutzen mit aus dem Halbleiterwafer gemäß Figur 5 getrennten, gestapelten Halbleiterchips auf einer Trägerfolie,
- Figur 7: zeigt einen schematischen Querschnitt durch einen Nutzen nach Entfernen der in Figur 5 gezeigten Trägerfolie,
- Figur 8: zeigt einen schematischen Querschnitt durch einen Nutzen gemäß Figur 7 mit aufgebrachter Umverdrahtungslage,
- Figur 9: zeigt einen schematischen Querschnitt durch einen Nutzen gemäß Figur 8 mit aufgebrachten Außenkontakten.

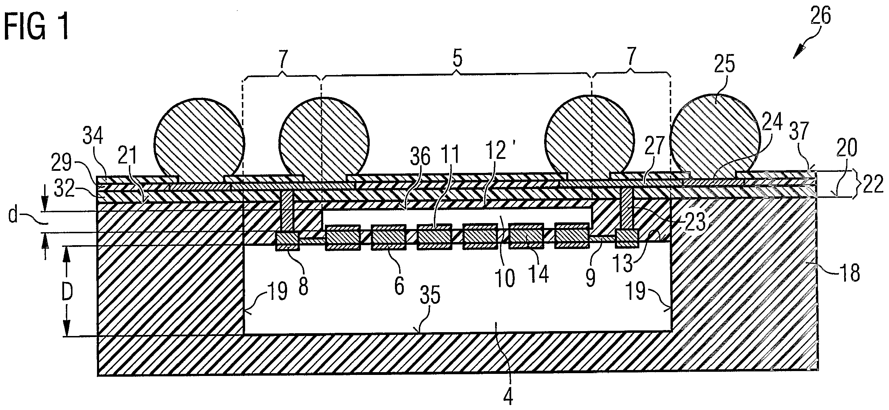

Figur 1 zeigt einen schematischen Querschnitt durch ein elektronisches Bauteil 26 hergestellt nach dem erfindungsgemäßen Verfahren. Das elektronische Bauteil 26 weist einen ersten Halbleiterchip 4 mit Randseiten 19 und einer Rückseite 35 auf. Die Oberseite 13 des ersten Halbleiterchips 4 weist in einem zentralen Bereich 5 Zentralkontaktflächen 6 und in ihrem Randbereich 7 Randkontaktflächen 8 auf. Auf dem zentralen Bereich 5 ist ein zweiter Halbleiterchip 10 angeordnet, der zweite Kontaktflächen 11 aufweist.

Zwischen den zweiten Kontaktflächen 11 und den Zentralkontaktflächen 6 sind Flip-Chip-Kontakte 14 angeordnet. Von den Zentralkontaktflächen 6 führen Leiterbahnen 9 zu den Randkontaktflächen 8. Die Zentralkontaktflächen 6 und damit auch jede der zweiten Kontaktflächen 11 ist über Leiterbahnen 9 mit einer der Randkontaktflächen 8 verbunden. Der zweite Halbleiterchip 10 mit seinen Flip-Chip-Kontakten 14 ist in eine Einebnungsschicht 12' eingebettet. Diese Einebnungsschicht 12' bedeckt sowohl die Rückseite 36 des zweiten Halbleiterchips 10 als auch die Randseiten 19 dieses Halbleiterchips 10 und füllt Zwischenräume zwischen den Flip-Chip-Kontakten 14 auf.

In den Randbereichen 7 erstrecken sich Durchkontakte 23 von den Randkontaktflächen 8 mindestens bis zur Oberseite 20 der Einebnungsschicht 12'. Die Einebnungsschicht 12' mit ihrer Oberseite 20 und die Kunststoffmasse 18, in die der Stapel aus zwei Halbleiterchips 4 und 10 eingebettet ist, bilden eine gemeinsame Fläche 21 aus, auf der eine Umverdrahtungslage 22 angeordnet ist. Diese Umverdrahtungslage 22 weist zwei Schichten auf, eine Übergangsschicht 32, die aus Polyamid besteht, und eine Umverdrahtungsschicht 29, die Umverdrahtungsleitungen 27 aufweist, welche mit den Durchkontakten 23 verbunden sind.

Darüber hinaus weist die Umverdrahtungsstruktur der Umverdrahtungsschicht 29 Außenkontaktflächen 24 auf, die von Außenkontakten 25 belegt sind. Auf der Umverdrahtungsstruktur der Umverdrahtungsschicht 38 ist eine Lötstoppschicht 34 angeordnet, die lediglich die Außenkontaktflächen 24 freilässt, sodass beim Anschmelzen der Außenkontakte 25 kein Lot auf die Umverdrahtungsleitungen 27 gelangen kann.

Während der erste Halbleiterchip 4 eine Dicke D aufweist, die einem Standardhalbleiterwafer entspricht, ist der zweite Halbleiterchip 10 dünngeschliffen, sodass ein relativ kompaktes elektronisches Bauteil 26 herstellbar ist. Die Außenkontakte 25 sind in dieser Ausführungsform in zwei Reihen angeordnet, sie können aber auch auf der Oberseite 36 der Umverdrahtungslage 22 gleichmäßig verteilt angeordnet sein. Bei diesem elektronischen Bauteil 26 besteht kein direkter Zugriff zu den Flip-Chip-Kontakten 14 des zweiten elektronischen Bauteils 10, jedoch wird durch die Randkontaktflächen 8 in Zusammenwirken mit den Durchkontakten 23 ein Zugriff auch zu den Flip-Chip-Kontakten 14 des zweiten Halbleiterchips möglich.

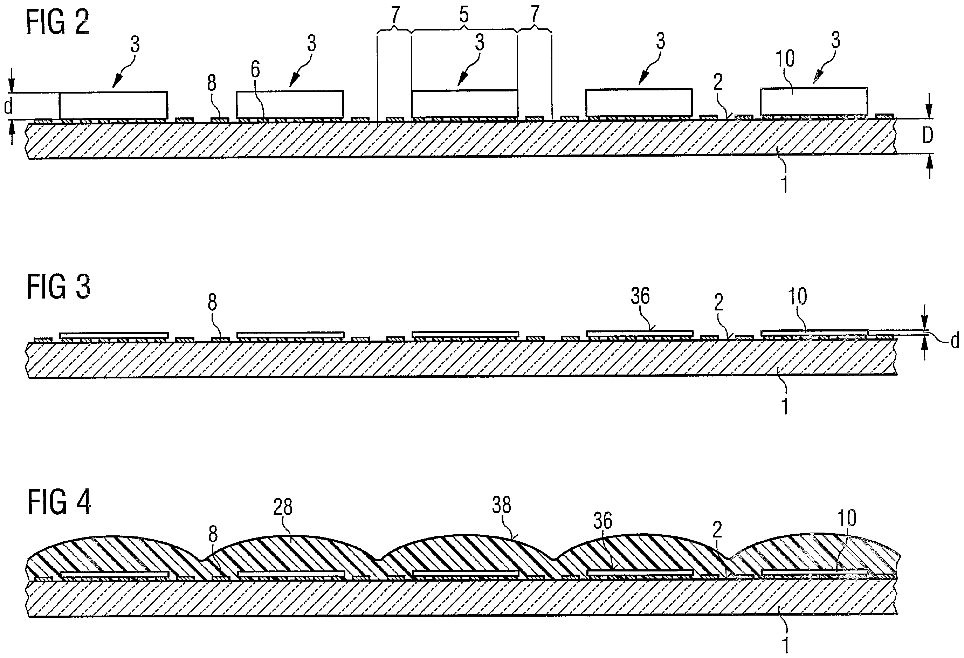

Die Figuren 2 bis 9 zeigen schematische Querschnitte durch Komponenten der Erfindung nach entsprechenden Herstellungsschritten. Komponenten mit den gleichen Funktionen wie in den Figuren 2 bis 9 werden mit gleichen Bezugszeichen gekennzeichnet und größtenteils nur einmal erörtert.

Figur 2 zeigt einen schematischen Querschnitt durch einen Halbleiterwafer 1 mit Bauteilpositionen 3, auf denen zweite Halbleiterchips 10 angeordnet sind. Jede Bauteilposition 3 weist einen Zentralbereich 5 mit Zentralkontaktflächen 6 auf. Um den Zentralbereich 5 herum ist ein Randbereich 7 in jeder Bauteilposition angeordnet, der Randkontaktflächen 8 trägt. Auf dem zentralen Bereich 5 ist der zweite Halbleiterchip 10 derart angeordnet, dass seine zweiten Kontaktflächen mit den Zentralkontaktflächen in jeder Chipposition elektrisch in Verbindung stehen. Die Dicke d der zweiten Halbleiterchips 10 auf dem Halbleiterwafer 1 entspricht in etwa der Dicke D des Halbleiterwafers.

Figur 3 zeigt einen schematischen Querschnitt durch den Halbleiterwafer 1 gemäß Figur 2 nach einem Dünnschleifen der zweiten Halbleiterchips 10. Durch das Dünnschleifen der Halbleiterchips 10, die auf dem Halbleiterwafer 1 angeordnet sind, kann eine Dicke d von 50 bis 80 µm erreicht werden, gegenüber einer Dicke D des Halbleiterwafers 1 von 500 bis 750 µm. Das Dünnschleifen wird dadurch erleichtert, dass der Halbleiterwafer 1 bereits eine planare Oberseite 2 aufweist, auf die mit etwa 20 µm dicken Flip-Chip-Kontakten die zweiten Halbleiterchips 10 aufgebracht sind und über diese Flip-Chip-Kontakte während des Dünnschleifvorgangs zuverlässig fixiert sind.

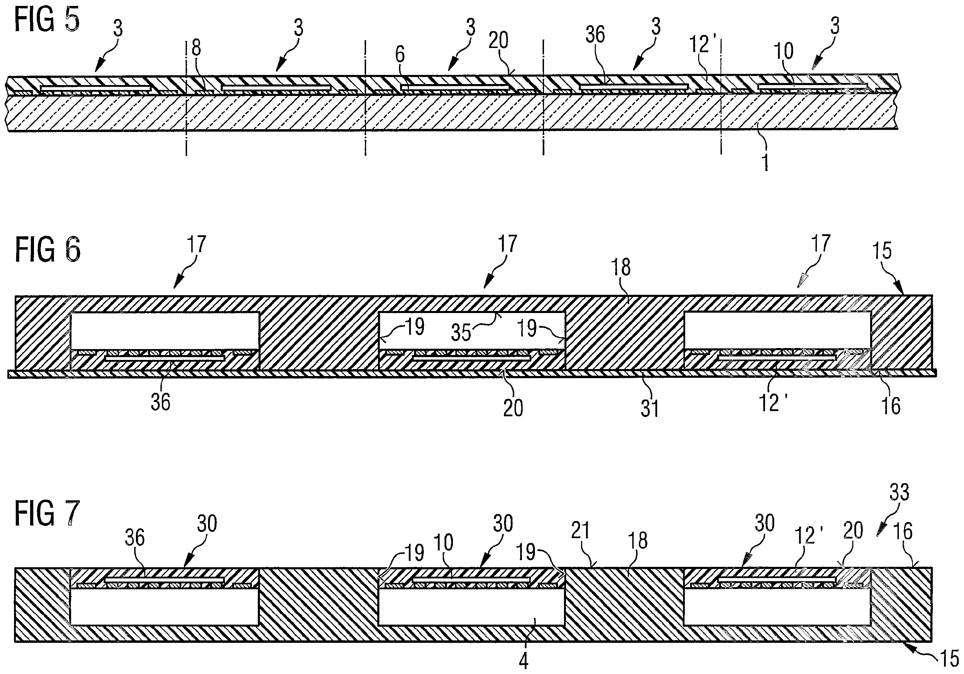

Figur 4 zeigt einen schematischen Querschnitt durch den Halbleiterwafer 1 gemäß Figur 3 nach einem Aufbringen einer Einebnungsmasse 28 auf die mit Halbleiterchips 10 bestückte Oberseite 2 des Halbleiterwafers 1. Diese Einebnungsmasse beispielsweise aus Polyimid wird zunächst dünnflüssig aufgetragen, wobei sich eine relativ unebene Oberfläche 37 ausbildet. Diese Oberfläche 37 kann bearbeitet werden, sodass, wie Figur 5 zeigt, die Einebnungsmasse 28 zu einer ebenen Einebnungsschicht 12 abgetragen ist. Ein wie in Figur 5 gezeigter Halbleiterwafer 1 ist bereits ein Handelsgut und kann kostengünstig verkauft werden, weil das Stapeln und Dünnschleifen von zweiten Halbleiterchips 10 auf dem Halbleiterwafer 1 ohne erheblichen Ausschuss hergestellt werden kann.

Figur 6 zeigt einen schematischen Querschnitt durch einen Nutzen 15 mit aus dem Halbleiterwafer 1 gemäß Figur 5 getrennten, gestapelten Halbleiterchips 4 und 10 auf einer Trägerfolie 31. Dafür wurde zunächst die Trägerfolie 31 bereitgestellt und die aus dem Halbleiterwafer 1 der Figur 5 gewonnenen gestapelten Halbleiterchips 4 und 10 mit ihren Einebnungsschichten 12' auf der Trägerfolie 31 angeordnet. Anschließend wurden die Zwischenräume zwischen den gestapelten Halbleiterchips 4 und 10 und die Rückseiten 35 der ersten Halbleiterchips 4 vollständig mit Kunststoff bedeckt. Durch die Trägerfolie 31 wird verhindert, dass auch die Oberseite 20 der Einebnungsschicht 12' mit Kunststoff bedeckt wird, sodass nach dem Aushärten der Kunststoffmasse 18 des Nutzens 15 die Folie 31 von den Bauteilpositionen 17 des Nutzens 15 abgezogen werden kann.

Figur 7 zeigt einen schematischen Querschnitt durch einen Nutzen 15 nach Entfernen der in Figur 5 gezeigten Trägerfolie 31. Die aus Kunststoffmasse 18 und Halbleiterchipstapeln 30 bestehende Kunststoffverbundplatte 33 ist selbsttragend und formstabil. Die Einebnungsschichten 12' mit ihren Oberseiten 20 bilden mit der dazwischen angeordneten Kunststoffmasse 18 eine gemeinsame Oberseite 21 aus. Diese gemeinsame Oberseite 21 ist eben beziehungsweise planar und somit können auf dieser ebenen Fläche weitere Strukturierungen zur Herstellung von elektronischen Bauteilen in den Bauteilpositionen des Nutzens 15 hergestellt werden. Zunächst werden Öffnungen mithilfe einer Photolithographie in die Einebnungsschichten bis hinunter zu den Randkontaktflächen eingearbeitet. Diese Durchgangsöffnungen werden anschließend mit einem Metall galvanisch zu einem Durchkontakt aufgefüllt. Nach dem Herstellen dieser Durchkontakte, deren Säulendurchmesser kleiner ist als der Durchmesser der Flip-Chip-Kontakte des zweiten elektronischen Bauteils 10, kann auf der ebenen Oberseite 21 eine Umverdrahtungslage aufgebracht werden. Obgleich die Anzahl der Durchkontakte der Anzahl der Flip-Chip-Kontakte entspricht, beanspruchen die Durchkontakte eine kleinere Fläche im Randbereich des ersten Halbleiterchips 4 als die Flip-Chip-Kontakte in dem zentralen Bereich des ersten Halbleiterchips 4.

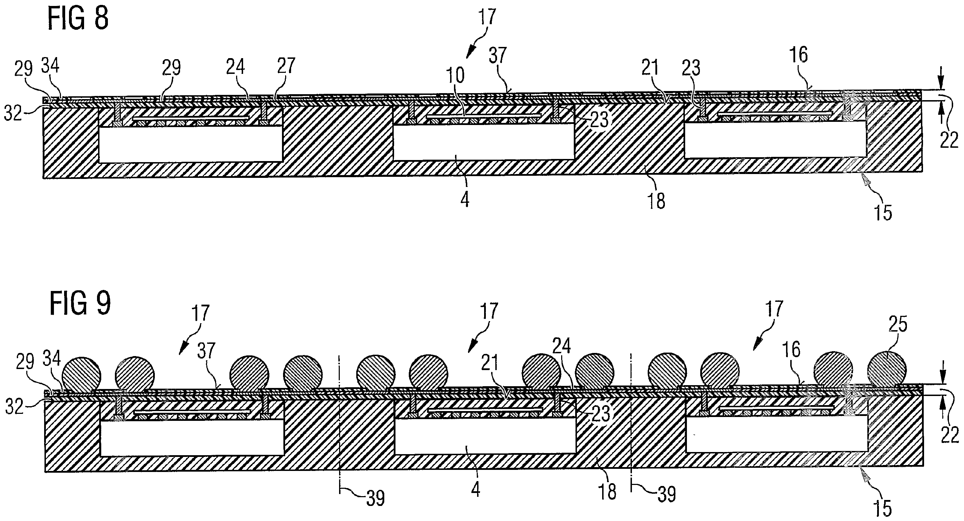

Figur 8 zeigt einen schematischen Querschnitt durch einen Nutzen 15 gemäß Figur 7 mit aufgebrachter Umverdrahtungslage 22. Diese Umverdrahtungslage 22 weist drei Schichten auf, eine Übergangsschicht 32 aus Polyimid, die zum Ausgleich auf die gemeinsame Fläche 21 des Nutzens 15 unter Freilassung der Durchkontakte 23 aufgebracht ist, eine weitere Schicht 29, die eine Umverdrahtungsstruktur aufweist, welche Umverdrahtungsleitungen 27 und Außenkontaktflächen 24 aufweist, wobei die Umverdrahtungsleitungen 27 die Durchkontakte 23 mit den Außenkontaktflächen 24 verbinden.

Figur 9 zeigt einen schematischen Querschnitt durch einen Nutzen 15 gemäß Figur 8 mit aufgebrachten Außenkontakten 25. Damit ist in jeder Bauteilposition 17 des Nutzens 15 ein komplettes Bauteil mit gestapelten Halbleiterchips vollendet und der Nutzen 15 kann entlang der Trennlinien 39 zu einzelnen Bauteilen aufgetrennt werden. Diese Schrittfolge des erfindungsgemäßen Verfahrens von einem Halbleiterwafer bis hin zu einem zu Bauteilen auftrennbaren Nutzen 15 wird dann eingesetzt, wenn die Fläche des ersten Halbleiterchips nicht ausreicht, um genügend Platz für Außenkontakte 25 zu bieten. Reicht jedoch die Oberfläche des Halbleiterchips aus, um genügend Außenkontakte auf einer Umverdrahtungslage auf dem Halbleiterchip unmittelbar aufzubringen, so kann gemäß einem nicht zur Erfindung gehörenden Verfahren auf die Ausbildung eines Nutzens 15 verzichtet werden und sämtliche Schritte zur Herstellung eines elektronischen Bauteils mit gestapelten Halbleiterchips unmittelbar auf einem Halbleiterwafer erfolgen.

## Patentansprüche

1. Verfahren zur Herstellung eines Nutzens (15) mit Halbleiterchipstapeln (30), das folgende Verfahrensschritte aufweist:
Bereitstellen eines Halbleiterwafers (1), der in Zeilen und Spalten angeordnete Halbleiterchippositionen (3) mit integrierten Schaltungen für erste Halbleiterchips (4) aufweist, wobei die Halbleiterchippositionen (3) jeweils einen zentralen Bereich (5) mit Zentralkontaktflächen (6) und einen Randbereich (7) mit Randkontaktflächen (8) aufweisen und wobei die Zentralkontaktflächen (6) mit den Randkontaktflächen (8) über Leiterbahnen (9) elektrisch verbunden sind,
Bestücken des Halbleiterwafers (1) mit zweiten Halbleiterchips (10) in zentralen Bereichen (5) der Halbleiterchippositionen (3) unter Freilassen der Randkontaktflächen (8), sodass die zweiten Halbleiterchips (10) über Flip-Chip-Kontakte mit den Zentralkontaktflächen (6) verbunden sind,
Dünnschleifen der zweiten Halbleiterchips (10) auf dem Halbleiterwafer (1),
Aufbringen einer Einebnungsmasse (28) auf den Halbleiterwafer (1) unter Einbetten der zweiten Halbleiterchips (10),
Bearbeiten der Einebnungsmasse (28) zu einer ebenen Einebnungsschicht (12),
Trennen des Halbleiterwafers (1) in einzelne Halbleiterchipstapel (30), die jeweils einen ersten und einen zweiten Halbleiterchip (4,10) sowie einen Teil der Einebnungsschicht (12) als eine Einebnungsschicht (12') des Halbleiterstapels (30) aufweisen,
Aufbringen der Halbleiterchipstapel (30) auf eine Trägerfolie (31), indem deren Einebnungsschichten (12') auf die Trägerfolie (31) geklebt werden, in Zeilen und Spalten für entsprechend vorgesehene Bauteilpositionen des Nutzens,
Einbetten der Halbleiterchipstapel (30) in eine Kunststoffmasse (18) unter Bilden einer Kunststoffverbundplatte (33) mit Bauteilpositionen (17),
Entfernen der Trägerfolie (31) von der Kunststoffverbundplatte (33),
Einbringen von Durchgangsöffnungen zu den Randkontaktflächen (8) des ersten Halbleiterchips (4) in die Einebnungsschichten (12'),
Auffüllen der Durchgangsöffnungen mit Kupfer oder einer Kupferlegierung zu Durchkontakten (23),
Aufbringen einer Umverdrahtungslage (22) auf der Kunststoffverbundplatte (33) mit Umverdrahtungsleitungen (27) von den Durchkontakten (23) zu Außenkontaktflächen (24) der Umverdrahtungslage (22) in den Bauteilpositionen (3) des Nutzens,
Aufbringen einer Lötstoppschicht (34) auf die Umverdrahtungslage (22) unter Freilassen der Außenkontaktflächen (24),
Aufbringen von Außenkontakten (25) auf die Außenkontaktflächen (24), wobei Außenkontakte (25) auf der Kunststoffmasse (18) des Nutzens angeordnet sind.

2. Verfahren zur Herstellung elektronischer Bauteile (26) mit folgenden Verfahrensschritten:
Herstellen eines Nutzens (15) gemäß Anspruch 1,
Trennen des Nutzens (15) in einzelne elektronische Bauteile (26).

## Claims

1. Method for the manufacture of a panel (15) with semiconductor chip stacks (30), which comprises the following method steps:
providing a semiconductor wafer (1), which has semiconductor chip positions (3) arranged in rows and columns with integrated circuits for first semiconductor chips (4), the semiconductor chip positions (3) each having a central region (5) with central contact areas (6) and an edge region (7) with edge contact areas (8) and the central contact areas (6) being electrically connected to the edge contact areas (8) by way of interconnects (9),
populating the semiconductor wafer (1) with second semiconductor chips (10) in central regions (5) of the semiconductor chip positions (3) while leaving the edge contact areas (8) free, so that the second semiconductor chips (10) are connected to the central contact areas (6) by way of flip-chip contacts,
thinning the second semiconductor chips (10) on the semiconductor wafer (1),
applying a levelling compound (28) to the semiconductor wafer (1) while embedding the second semiconductor chips (10),
working the levelling compound (28) to form an even levelling layer (12),
separating the semiconductor wafer (1) into individual semiconductor chip stacks (30), which each have a first and a second semiconductor chip (4, 10) and also a part of the levelling layer (12) as a levelling layer (12') of the semiconductor stack (30),
applying the semiconductor chip stacks (30) to a substrate (31), by their levelling layers (12') being adhesively attached to the substrate (31), in rows and columns for correspondingly provided component positions of the panel,
embedding the semiconductor chip stacks (30) in a polymer compound (18) while forming a composite plastic sheet (33) with component positions (17),
removing the substrate (31) from the composite plastic sheet (33),
introducing into the levelling layers (12') passages to the edge contact areas (8) of the first semiconductor chip (4),
filling the passages with copper or a copper alloy to form vias (23),
applying a redistribution layer (22) on the composite plastic sheet (33) with redistribution lines (27) from the vias (23) to outer contact areas (24) of the redistribution layer (22) in the component positions (3) of the panel,
applying a solder resist layer (34) to the redistribution layer (22) while leaving the outer contact areas (24) free,
applying outer contacts (25) to the outer contact areas (24), outer contacts (25) being arranged on the polymer compound (18) of the panel.

2. Method for the manufacture of electronic components (26) comprising the following method steps:
manufacturing a panel (15) according to Claim 1,
separating the panel (15) into individual electronic components (26).

## Revendications

1. Procédé de fabrication d'un flanc (15) avec des piles de puces à semi-conducteur (30) qui présente les étapes de procédé suivantes :
mise à disposition d'une tranche de semi-conducteur (1) qui présente des positions de puce à semi-conducteur (3) disposées en lignes et colonnes avec des circuits intégrés pour des premières puces à semi-conducteur (4), dans lequel les positions de puce à semi-conducteur (3) présentent chacune une région centrale (5) avec des faces de contact centrales (6) et une région de bord (7) avec des faces de contact de bord (8), et dans lequel les faces de contact centrales (6) sont connectées électriquement aux faces de contact de bord (8) par le biais de pistes conductrices (9),
équipement de la tranche de semi-conducteur (1) de secondes puces à semi-conducteur (10) dans des régions centrales (5) des positions de puce à semi-conducteur (3) en libérant les faces de contact de bord (8) de sorte que les secondes puces à semi-conducteur (10) sont connectées par le biais de contacts de puce retournée aux faces de contact centrales (6),
coupe fine des secondes puces à semi-conducteur (10) sur la tranche de semi-conducteur (1),
application d'une masse de nivellement (28) sur la tranche de semi-conducteur (1) en encastrant les secondes puces à semi-conducteur (10),
usinage de la masse de nivellement (28) en une couche de nivellement plane (12),
séparation de la tranche de semi-conducteur (1) en piles de puces à semi-conducteur individuelles (30) qui présentent chacune une première et une seconde puces à semi-conducteur (4, 10) ainsi qu'une partie de la couche de nivellement (12) en tant que couche de nivellement (12') de la pile de puces à semi-conducteur (30),
application des piles de puces à semi-conducteur (30) sur une feuille de support (31) en ce que leurs couches de nivellement (12') sont collées sur la feuille de support (31), en lignes et colonnes pour des positions de composant prévues en conséquence du flanc,
encastrement des piles de puces à semi-conducteur (30) dans une masse plastique (18) avec formation d'une plaque composite plastique (33) avec des positions de composant (17),
retrait de la feuille de support (31) de la plaque composite plastique (33),
introduction d'ouvertures de passage vers les faces de contact de bord (8) de la première puce à semi-conducteur (4) dans les couches de nivellement (12'),
remplissage des ouvertures de passage avec du cuivre ou un alliage de cuivre vers des trous métallisés (23),
application d'une couche de recâblage (22) sur la plaque composite plastique (33) avec des lignes de recâblage (27) des trous métallisés (23) vers des faces de contact externes (24) de la couche de recâblage (22) dans les positions de composant (3) du flanc,
application d'une couche d'arrêt de brasage (34) sur la couche de recâblage (22) en libérant les faces de contact externes (24),
application de contacts externes (25) sur les faces de contact externes (24), dans lequel des contacts externes (25) sont disposés sur la masse plastique (18) du flanc.

2. Procédé de fabrication de composants électroniques (26) avec les étapes de procédé suivantes :
fabrication d'un flanc (15) selon la revendication 1,
séparation du flanc (15) en composants électroniques individuels (26).
